# EUROPÄISCHE PATENTSCHRIFT

(11) **EP 2 652 369 B1**
(45) Veröffentlichungstag und Bekanntmachung des Hinweises auf die Patenterteilung: **29.04.2015**
(21) Anmeldenummer: 11764688.5
(22) Anmeldetag: 04.10.2011
(51) Int. Cl.: F16J 15/34, C23C 16/27

(54) **REIBUNGSARMER GLEITRING MIT KOSTENGÜNSTIGER DIAMANTBESCHICHTUNG**
LOW-FRICTION SLIDING RING HAVING AN ECONOMICAL DIAMOND COATING
BAGUE DE GLISSEMENT À FAIBLE FROTTEMENT PORTANT UN REVÊTEMENT DE DIAMANT ÉCONOMIQUE

(30) Priorität: 17.12.2010 DE 102010054875
(43) Veröffentlichungstag der Anmeldung: 23.10.2013
(73) Patentinhaber: EagleBurgmann Germany GmbH & Co. KG, 82515 Wolfratshausen (DE)
(72) Erfinder: OTSCHIK , Joachim, 63741 Aschaffenburg (DE); SCHRÜFER, Andreas, 82515 Wolfratshausen (DE); ZIEGENBEIN, Dieter, 82538 Geretsried (DE); KOLLINGER, Rudolf, 82549 Königsdorf (DE); SCHÄFER, Lothar, 38527 Meine (DE); HÖFER, Markus, 38162 Gardessen (DE); ARMGARDT, Markus, 38100 Braunschweig (DE)
(74) Vertreter: Schaeberle, Steffen
(86) Internationale Anmeldenummer: PCT/EP2011/004942
(87) Internationale Veröffentlichungsnummer: WO 2012/079658

(56) Entgegenhaltungen:
- DE-U1-202006 006 425
- DE-U1-202007 016 868
- US-A- 5 626 908
- US-B1- 6 319 439

## Beschreibung

Die Erfindung betrifft einen reibungsarmen Gleitring, welcher als Gleitfläche eine kostengünstige Diamantbeschichtung aufweist. Ferner betrifft die Erfindung eine Gleitringdichtungsanordnung mit wenigstens einem erfindungsgemäßen Gleitring.

Gleitringe mit Diamantbeschichtung sind aus dem Stand der Technik in unterschiedlichen Ausgestaltungen bekannt. Diese Gleitringe weisen durch die Diamantbeschichtung eine extrem verschleißfeste Oberfläche sowie hervorragende Trockenlaufeigenschaften auf. Ein Nachteil derartiger diamantbeschichteter Gleitringe ist neben den zum Teil extrem hohen Herstellungskosten auch die Problematik, dass es aufgrund einer mangelhaften Verbindung zwischen der Diamantschicht und dem Basiskörper des Gleitrings zu Ablösungen der Diamantschicht mit entsprechenden Schädigungen am Gleitring kommen kann. Zur Lösung dieses Problems wurde in der DE 20 2007 016 868.3 U1 ein Gleitring vorgeschlagen, welcher einen Basiskörper aus einem Zweikomponentenmaterial aufweist, wobei ein Diamantmaterial in den Basiskörper eingebracht ist. Hierdurch wird zwar eine verbesserte Verbindung zwischen dem Basiskörper und der Diamantschicht erhalten, da jedoch Diamant als zusätzliches Material in den Basiskörper eingebracht wird, sind derartige Gleitringe noch teurer in ihrer Herstellung. Weiterhin ist aus der DE 20 2006 006 425 U1 ein Gleitring bekannt, bei dem auf einem Basiskörper mit entsprechendem Aufwand eine zusätzliche Substratschicht zwischen dem Basiskörper und der Diamantschicht aufgebracht ist. Ferner ist es bei diamantbeschichteten Gleitringen problematisch, dass es zu kompletten Ablösungen der Diamantschicht mit Teilen des Basiskörpers kommen kann.

Es ist daher Aufgabe der vorliegenden Erfindung, einen Gleitring mit einer Diamantbeschichtung an der Gleitfläche bereitzustellen, welcher bei einfacher und kostengünstiger Herstellbarkeit eine sichere Verbindung zwischen Basiskörper und der Diamantschicht auch bei extremen Beanspruchungen bereitstellt.

Diese Aufgabe wird durch einen Gleitring mit den Merkmalen des Anspruchs 1 gelost. Die Unteransprüche zeigen bevorzugte Weiterbildungen der Erfindung.

Der erfindungsgemäße Gleitring für eine Gleitringdichtung mit den Merkmalen des Anspruchs 1 weist den Vorteil auf, dass er eine Diamantschicht an einer Gleitfläche aufweist und somit eine hohe Lebensdauer und insbesondere hervorragende Trockenlaufeigenschaften aufweist. Dabei ist eine Herstellung der Diamantschicht sehr kostengünstig, da die Diamantschicht nur eine Dicke von kleiner oder gleich 4 µm aufweist und eine hervorragende Verbindung zwischen der Diamantschicht und einem Basiskörper vorhanden ist. Hierdurch kann insbesondere die bisher im Stand der Technik auftretende Problematik eines Ablösens der Diamantschicht von dem Basiskörper, insbesondere zusammen mit Teilen des Basiskörpers, bei hohen Belastungen, z.B. hohen mechanischen Belastungen, an der Gleitringdichtung, vermieden werden. Dies wird erfindungsgemäß dadurch erreicht, dass der Basiskörper keine Risse oder nur Risse aufweist, welche eine maximale Längserstreckung aufweisen, die kleiner oder gleich 5 µm ist. Erfindungsgemäß wurde festgestellt, dass, falls keine bzw. nur sehr kleine Risse an der Oberfläche und im Basiskörper vorhanden sind, an jeder Stelle eine ausreichende Verbindung zwischen dem Basiskörper und der Diamantschicht sichergestellt werden kann. Wenn die Risse zu groß werden, gibt es im Bereich der Risse Defekte, so dass es in diesen Bereichen insbesondere bei hohen Belastungen, z.B. hohen mechanischen Belastungen, zu Ablösungen der Diamantschicht mit Teilen des Basiskörpers und letztendlich zu einem Zerstören des Gleitrings kommen kann. Die Längserstreckung der Risse von kleiner gleich 5 µm ist erfindungsgemäß derart definiert, dass eine Gerade, welche zwei Punkte des Risses schneidet, an jedem möglichen Schnittpunkt mit dem Riss zwischen den Schnittpunkten eine Länge von kleiner oder gleich 5 µm aufweist. Die erfindungsgemäße Grenze von 5 µm für die Risslänge gilt dabei für Risse an der Oberfläche und Risse im Basiskörper selbst, welche z.B. ausgehend von der Oberfläche in das Innere des Basiskörpers laufen. Erfindungsgemäß weist somit ein Basiskörper sowohl an einer Oberfläche, an der die Diamantschicht aufgebracht ist, als auch im Basiskörper selbst keine Risse oder nur Risse mit einer maximalen Längserstreckung von ≤ 5 µm auf. Um z.B. eine Rissgröße an einer Oberfläche des Basiskörpers, wie oben definiert, zu erhalten, wird vorzugsweise eine Feinbearbeitung der Oberfläche, z.B. ein Poliervorgang, vorgenommen. Somit ist es erfindungsgemäß möglich, einen Gleitring mit einer Diamantbeschichtung mit kleiner Dicke vorzusehen, welche kostengünstig herstellbar ist und dem Gleitring außergewöhnliche Standzeiten und Trockenlaufeigenschaften verleiht. Die Diamantschicht kann dabei auf dem rissfreien bzw. nur kleine Risse aufweisenden Basiskörper vorzugsweise mittels eines CVD-Verfahrens abgeschieden werden. Dadurch eröffnet sich ein wirtschaftlich sehr großes Anwendungspotential, da praktisch alle Arten von Gleitringen kostengünstig mit Diamant beschichtet werden können. Ein erfindungsgemäßer Gleitring weist einen sehr niedrigen Reibwert auf und stellt eine stabile Verbindung zwischen Diamantschicht und Basiskörper bereit. Vorzugsweise ist eine Dicke der Diamantschicht kleiner als 4 µm, vorzugsweise kleiner als 3 µm, besonders bevorzugt kleiner als 2 µm und besonders bevorzugt beträgt die Diamantschichtdicke etwa 1 µm. Weiter bevorzugt ist eine Risslänge kleiner als 3 µm und besonders bevorzugt kleiner als 1 µm bzw. es sind überhaupt keine Risse vorhanden.

Weiter bevorzugt ist eine Tiefe der Risse, ausgehend von der Oberfläche senkrecht zur Oberfläche kleiner oder gleich 3 µm.

Weiter bevorzugt ist die Dicke der Diamantschicht mindestens 0,5 µm. Hierdurch wird sichergestellt, dass die Diamantschicht einen ausreichenden Schutz gegen aggressive oder korrosive Medien, mit welchen die Gleitringe in Kontakt kommen können, bietet.

Gemäß einer weiteren bevorzugten Ausgestaltung der vorliegenden Erfindung ist die Oberfläche des Basiskörpers porenfrei oder weist bevorzugt nur Poren mit einem mittleren Porendurchmesser von kleiner gleich 0,4 mm, vorzugsweise kleiner gleich 0,3 mm, besonders bevorzugt kleiner gleich 0,2 mm, auf.

Weiter bevorzugt sind die Poren in Abhängigkeit vom mittleren Porendurchmesser um den Faktor 100 des mittleren Porendurchmessers voneinander beabstandet. D.h., wenn der mittlere Porendurchmesser 0,4 mm beträgt, ist ein Abstand dieser Pore zu einer benachbarten Pore, ausgehend von den jeweiligen Rändern der Poren, mindestens 40 mm. Erfindungsgemäß wird dabei unter dem mittleren Porendurchmesser derjenige Durchmesser verstanden, welcher einer maximalen Länge einer Gerade zwischen zwei Randpunkten durch die Pore entspricht, da die Poren üblicherweise nicht kreisförmig sind.

Gemäß einer weiteren bevorzugten Ausgestaltung der Erfindung ist eine Kristallitgröße der als kristallinen Diamant niedergeschlagenen Diamantschicht zwischen 0,2 bis 5 µm, insbesondere 0,2 bis 4 µm, vorzugsweise 0,2 bis 3 µm, bevorzugt 0,2 bis 2,5 µm, weiter bevorzugt 0,2 bis 1 µm.

Weiter bevorzugt ist eine Rauhheit Rₐ der Oberfläche des Basiskörpers kleiner gleich 0,2 µm, insbesondere kleiner oder gleich 0,15 µm, und besonders bevorzugt kleiner gleich 0,1 µm.

Vorzugsweise ist ein SP3-Anteil in der Diamantschicht größer oder gleich 97%.

Gemäß einer weiteren bevorzugten Ausgestaltung der Erfindung weist der Basiskörper eine Vickershärte von mind. 1400 HV auf.

Um eine möglichst lange Lebensdauer aufzuweisen, ist eine Defektdichte in der Diamantbeschichtung derart, dass das Verhältnis der Defektfläche zu der defektfrei beschichteten Fläche kleiner oder gleich 200 x 10⁻⁹ ist.

Der Basiskörper ist vorzugsweise aus einem karbidischen Material, insbesondere aus Siliziumkarbid (SiC) oder Wolframkarbid (WC) hergestellt, wobei geringfügige Mengen an Zusatzstoffen und/oder Bindematerialen und/oder Verunreinigungen enthalten sein können.

Weiter bevorzugt entspricht eine Oberfläche der Diamantschicht einer Oberfläche des Basiskörpers mit einer Abweichung von höchstens ± 0,2 µm.

Ein erfindungsgemäßer Gleitring kann dabei in Gleitringdichtungen verwendet werden, bei denen beide Gleitringe mit der erfindungsgemäßen Diamantbeschichtung. ausgebildet sind. Alternativ kann der erfindungsgemäße Gleitring auch gegen einen nicht-beschichteten Gleitring, z.B. aus Siliziumkarbid, laufen.

Nachfolgend wird unter Bezugnahme auf die begleitende Zeichnung ein bevorzugtes Ausführungsbeispiel der Erfindung im Detail beschrieben. In der Zeichnung ist:
- Fig. 1: eine schematische Draufsicht auf eine Oberfläche eines Basiskörpers für einen Gleitring gemäß einem Ausführungsbeispiel der Erfindung, und
- Fig. 2: eine schematische Schnittansicht durch einen erfindungsgemäßen Gleitring.

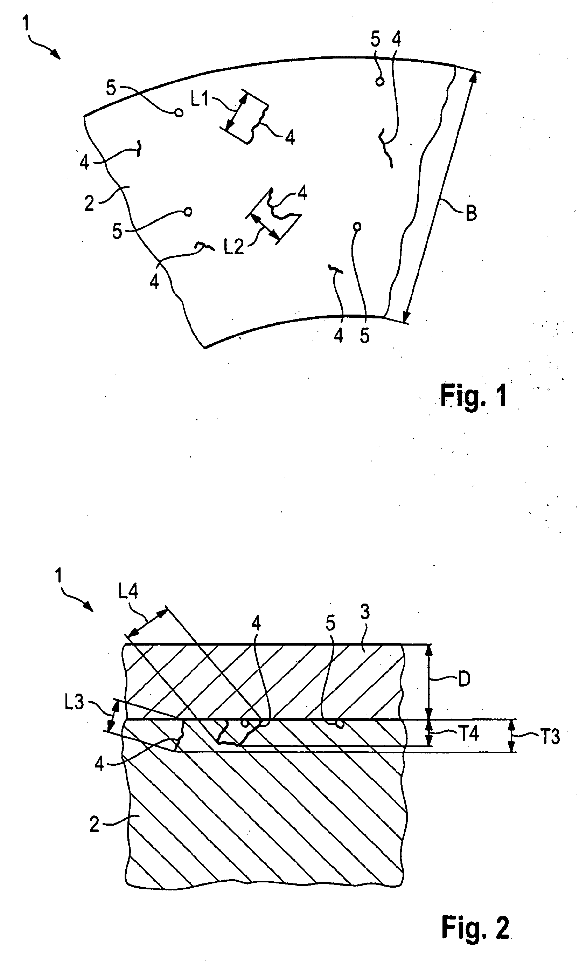

Wie aus Fig. 2 ersichtlich ist, umfasst der Gleitring 1 einen Basiskörper 2 aus SiC sowie eine darauf aufgebrachte Diamantschicht 3. Die Diamantschicht 3 weist eine Dicke D von 1 µm auf. Die Diamantschicht 3 ist aus kristallinem Diamant mit einem sehr hohen SP3-Anteil von über 97% gebildet.

Fig. 1 zeigt in Draufsicht eine Oberfläche des Basiskörpers 2 vor dem Aufbringen der Diamantschicht. Wie aus Fig. 1 ersichtlich ist, sind in der Oberfläche des Basiskörpers 2 einige Risse 4 gebildet. Die Risse 4 sind jedoch derart ausgebildet, dass sie eine maximale Längserstreckung aufweisen, welche kleiner als 5 µm ist. In Fig. 1 sind bei zwei Rissen die an der Oberfläche vorhandene maximale Längserstreckung L1 bzw. L2 eingezeichnet. Die maximale Längserstreckung ist erfindungsgemäß dabei als eine maximale gerade Strecke, welche zwei Punkte des Risses 4 in geradliniger Form verbindet, definiert.

Im Schnitt von Fig. 2 sind zwei weitere Risse 4 dargestellt, welche eine maximale Längserstreckung L3 bzw. L4 in die Tiefe des Basiskörpers 2 aufweisen, die jeweils kleiner als 5 µm sind. Dadurch weist der erfindungsgemäße Basiskörper 2 sowohl an der Oberfläche als auch im Körper selbst nur Risse 4 auf, welche eine maximale Längserstreckung von kleiner oder gleich 5 µm aufweisen. Die Längserstreckung ist durch eine Gerade definiert, welche zwei beliebige Punkte des Risses schneidet und an jedem möglichen Schnittpunkt zweier Punkte des Risses eine Länge von kleiner oder gleich 5 µm aufweist. Der in Fig. 2 gezeigte Riss 4 mit der Längserstreckung L3 weist dabei eine Tiefe T3 auf, die kleiner als 3 µm ist. In Fig. 2 ist ein weiterer Riss 4 mit einer Längserstreckung L4 und einer Tiefe T4 dargestellt, welcher an einer ersten Stelle der Oberfläche beginnt, in den Basiskörper 2 hineingeht und an einer anderen Stelle der Oberfläche des Basiskörpers wieder austritt. Hierbei sei angemerkt, dass der Riss auch eine dreidimensionale Rissfläche aufweisen kann, wobei er sowohl an der Oberfläche des Basiskörpers 2 als auch flächenartig in den Basiskörper 2 selbst hinein verläuft.

Ferner sind auf der Oberfläche des Basiskörpers 2 mehrere Poren 5 ausgebildet. Die Poren 5 weisen einen durchschnittlichen Durchmesser von kleiner oder gleich 0,4 mm auf, wobei der Abstand von benachbarten Poren mindestens das 100-fache des Porendurchmessers beträgt, d.h., in diesem Ausführungsbeispiel 40 mm. Der Porendurchmesser ist erfindungsgemäß definiert als längste Gerade durch zwei Randpunkte der Poren, da die Poren üblicherweise keine kreisrunde Form aufweisen, sondern einen ungleichförmigen Randbereich. Die Poren 5 weisen dabei eine Tiefe auf, welche maximal dem Durchmesser der Poren entspricht.

Ferner weisen alle Risse 4 eine Tiefe T auf, welche kleiner als 3 µm ist. Darüber hinaus entspricht die Oberfläche der Diamantschicht der Oberfläche des Basiskörpers mit einer Abweichung von höchstens ± 0,2 µm.

Die erfindungsgemäße kristalline Diamantschicht wird auf dem Basiskörper 2 dabei wie folgt hergestellt. Der zu beschichtende Gleitring wird in einem Vakuumbehälter angeordnet, in welchen anschließend Methan und Wasserstoff zugeführt wird. In einem Abstand von einigen cm über den zu beschichteten Gleitringen werden Drähte gespannt, welche dann bis zur Weißglut erhitzt werden. Hierdurch wird das Gas erhitzt, so dass sich Kohlenstoff auf der Oberfläche des Basiskörpers 2 in kristalliner Diamantform ablagert. Hierbei wird eine chemische Verbindung zwischen der Diamantschicht und dem Basiskörper 2 erreicht. Aufgrund der Rissefreiheit des Basiskörpers bzw. der Bedingung, dass nur Risse am bzw. im Basiskörper vorhanden sind, welche eine maximale Längserstreckung von kleiner oder gleich 5 µm aufweisen, wird eine hohe Grenzflächenstabilität erreicht.

Mit dem derartigen Verfahren wurde ein Basiskörper 2 aus SiC mit Diamant beschichtet (Beispiel 1). Der Basiskörper bzw. die Diamantschicht haben dabei die nachfolgenden Eigenschaften:

### Beispiel 1:

| **Eigenschaft** | **Wert** |
|---|---|
| Dicke | 1 µm |
| Kristallitgröße | 1,0 µm |
| Rauhheit Rₐ | 0,1 µm |
| SP3-Anteil | 97% |
| maximale Porengröße | 0,4 mm |
| Porenabstand | > 40 mm |
| maximale Risslänge | 5 µm |
| maximale Risstiefe | 3 µm |
| Vickershärte des Basiskörpers | 2600 HV |
| Defektdichte der Diamantbeschichtung | < 200 x 10⁻⁹ |

Die Dicke der Diamantschicht wurde dabei mit einem Betarückstreuverfahren gemessen. Die Kristallitgröße wurde mittels eines Lichtmikroskops mit einer 1000fachen Vergrößerung gemessen. Die Rauhheit Rₐ wurde mittels eines Weißlichtinterferometers und der SP3-Anteil mittels Raman-Spektroskopie bestimmt. Die Porengrößen und die Porenabstände wurden mittels eines Lichtmikroskops ermittelt und die Risslänge bzw. die Risstiefe durch Bestimmung einer Rissanzahlverteilung in einem lonen-Böschungsschnitt durch den Basiskörper 2, wobei der Schnitt eine Mindestschnittlänge von 1 mm aufwies. Die Härte des Substrats wurde mittels Vickers-Härteprüfung bestimmt und die Defektdichte durch ein Lichtmikroskop, wobei die Defektdichte als Flächenanteil der nichtbeschichteten Fehlstellen der Substratoberfläche zur mit Diamant beschichteten Oberfläche definiert ist.

Erfindungsgemäß ist es somit möglich, durch die Einstellung verschiedener Parameter des Basiskörpers 2 eine homogene und dauerhafte Diamantschicht mit einer Dicke von unter 3 µm auf der Basisoberfläche zu erzeugen, was bisher im Stand der Technik nicht möglich war. Ein Kern der Erfindung liegt dabei darin, dass der Basiskörper derart beschaffen sein muss, dass er keine Risse oder nur Risse aufweist, die eine Maximallänge von kleiner oder gleich 5 µm aufweisen. Durch Einhalten dieses Parameters kann dann eine stabile Diamantbeschichtung mit einer extrem dünnen Schichtdicke von kleiner oder gleich 4 µm erfolgen, was zu einer signifikanten Reduzierung der Herstellkosten führt, da die Beschichtungsdauer auf wenige Stunden reduziert werden kann. Weiterhin kann dadurch vermieden werden, dass sich die Diamantschicht mitsamt einem Teil der Basisschicht löst. Die Vermeidung großer Risse stellt somit auch einen stabilen Verband innerhalb der Basisschicht bereit. Durch die extrem dünne Diamantbeschichtung können ferner Gleitringe mit hervorragenden Eigenschaften, insbesondere hinsichtlich Standzeit und Notlaufeigenschaften erhalten werden. Dadurch kann insbesondere bei der Erdöl- und Erdgasförderung die Lebensdauer von Gleitringen, welche zum Teil aufgrund der schweren Einsatzbedingungen nur wenige Stunden betragen, signifikant erhöht werden. Ferner bildet die Diamantschicht 3 auch einen hervorragenden Korrosionsschutz für den Gleitring. Durch die erfindungsgemäße Idee der Reduzierung der Risslängen an der Oberfläche des Basiskörpers und im Basiskörper 2 selbst kann eine Diamantbeschichtung mit einer Dicke von kleiner oder gleich 4 µm erreicht werden. Hierdurch ist es erstmals möglich, dass Gleitringe auch für normale Anwendungsfälle, wie z.B. in Pumpen für Großserien, bei denen die Kosten für die Gleitringe eine große Rolle spielen, mit einer Diamantschicht beschichtet werden kann.

## Patentansprüche

1. Gleitring für eine Gleitringdichtung, umfassend
- einen Basiskörper (2) mit einer auf dem Basiskörper (2) aufgebrachten Diamantschicht (3), welche als Gleitfläche ausgebildet ist,
- wobei die Diamantschicht (3) eine Dicke (D) aufweist, welche kleiner oder gleich 4 µm, insbesondere kleiner oder gleich 3 µm, insbesondere kleiner oder gleich 2 µm, besonders bevorzugt etwa 1 µm, ist, **dadurch gekennzeichnet,**
- **dass** der Basiskörper (2) keine Risse oder nur Risse aufweist, welche eine maximale Längserstreckung (L) an einer Oberfläche des Basiskörper (2) oder im Basiskörper (2) aufweisen, die kleiner oder gleich 5 µm ist.

2. Gleitring nach Anspruch 1, **dadurch gekennzeichnet, dass** die Risse (4) im Basiskörper (2) eine Risstiefe (T) von kleiner oder gleich 3 µm aufweisen.

3. Gleitring nach einem der vorhergehenden Ansprüche, **dadurch gekennzeichnet, dass** die Diamantschicht,(3) eine Dicke von mindestens 0,5 µm aufweist.

4. Gleitring nach einem der vorhergehenden Ansprüche, **dadurch gekennzeichnet, dass** die Oberfläche des Basiskörpers (2) porenfrei ist oder dass die Oberfläche nur Poren mit einem mittleren Porendurchmesser von kleiner oder gleich 0,4 mm, insbesondere kleiner gleich 0,3 mm, besonders bevorzugt kleiner oder gleich 0,2 mm, aufweist, und/oder dass die Poren (5) voneinander einen Abstand von mindestens des 100fachen des Porendurchmessers aufweisen.

5. Gleitring nach einem der vorhergehenden Ansprüche, **dadurch gekennzeichnet, dass** eine Kristallitgröße der Diamanten der Diamantschicht (3) zwischen 0,2 bis 5 µm, insbesondere 0,2 bis 4 µm, vorzugsweise 0,2 bis 3 µm, bevorzugt 0,2 bis 2,5 µm und insbesondere 0,2 bis 1 µm, beträgt.

6. Gleitring nach einem der vorhergehenden Ansprüche, **dadurch gekennzeichnet, dass** die Diamantschicht (3) eine Rauhheit (Rₐ) von kleiner oder gleich 0,2 µm, insbesondere kleiner oder gleich 0,15 µm, insbesondere kleiner oder gleich 0,1 µm, aufweist.

7. Gleitring nach einem der vorhergehenden Ansprüche, **dadurch gekennzeichnet, dass** die Diamantschicht (3) ein SP3-Anteil von größer oder gleich 97% aufweist.

8. Gleitring nach einem der vorhergehenden Ansprüche, **dadurch gekennzeichnet, dass** der Basiskörper (2) eine Vickershärte von größer oder gleich 1400 HV aufweist.

9. Gleitring nach einem der vorhergehenden Ansprüche, **dadurch gekennzeichnet, dass** eine Defektdichte der Diamantschicht (3) kleiner oder gleich 200 x 10⁻⁹ ist, wobei die Defektdichte das Verhältnis der Defektflächen zur defektfrei beschichteten Fläche der Oberfläche ist.

10. Gleitring nach einem der vorhergehenden Ansprüche, **dadurch gekennzeichnet, dass** der Basiskörper (2) aus einem karbidischen Material, insbesondere aus Siliziumkarbid (SiC) oder Wolframkarbid (WC), hergestellt ist.

11. Gleitring nach einem der vorhergehenden Ansprüche, **dadurch gekennzeichnet, dass** die Oberfläche der Diamantschicht einer Oberfläche des Basiskörpers (2) mit einer Abweichung von höchstens ± 0,2 µm entspricht.

## Claims

1. A seal ring for a mechanical seal, comprising:
- a base body (2) with a diamond layer (3) which is applied to the base body (2) and configured as a sliding surface,
- wherein the diamond layer (3) has a thickness (D) which is less than or equal to 4 µm, particularly less than or equal to 3 µm, particularly less than or equal to 2 µm, particularly preferably about 1 µm, **characterized in**
- **that** the base body (2) is without fissures or only comprises fissures that have a maximum longitudinal extension (L) on a surface of the base body (2) or in the base body (2) that is less than or equal to 5 µm.

2. The seal ring according to claim 1, **characterized in that** the fissures (4) in the base body (2) have a fissure depth (T) of less than or equal to 3 µm.

3. The seal ring according to any of the preceding claims, **characterized in that** the diamond layer (3) has a thickness of at least 0.5 µm.

4. The seal ring according to any of the preceding claims, **characterized in that** the surface of the base body (2) is without pores or that the surface only comprises pores having a mean pore diameter of less than or equal to 0.4 mm, particularly less than or equal to 0.3 mm, particularly preferably less than or equal to 0.2 mm, and/or that the pores (5) have a distance from one another of at least 100 times the pore diameter.

5. The seal ring according to any of the preceding claims, **characterized in that** a crystallite size of the diamonds of the diamond layer (3) is between 0.2-5 µm, particularly 0.2-4 µm, preferably 0.2-3 µm, preferably 0.2-2.5 µm, and particularly 0.2-1 µm.

6. The seal ring according to any of the preceding claims, **characterized in that** the diamond layer (3) has a roughness (Rₐ) of less than or equal to 0.2 µm, particularly less than or equal to 0.15 µm, particularly less than or equal to 0.1 µm.

7. The seal ring according to any of the preceding claims, **characterized in that** the diamond layer (3) has an SP3 fraction of more than or equal to 97%.

8. The seal ring according to any of the preceding claims, **characterized in that** the base body (2) has a Vickers hardness of more than or equal to 1400 HV.

9. The seal ring according to any of the preceding claims, **characterized in that** a defect density of the diamond layer (3) is less than or equal to 200 x 10⁻⁹, wherein the defect density is the ratio of the defect areas to the area of the surface that is coated without any defects.

10. The seal ring according to any of the preceding claims, **characterized in that** the base body (2) is made from a carbide material, particularly silicon carbide (SiC) or tungsten carbide (WC).

11. The seal ring according to any of the preceding claims, **characterized in that** the surface of the diamond layer corresponds to a surface of the base body (2) with a deviation of not more than ± 0.2 µm.

## Revendications

1. Bague de glissement pour une garniture d'étanchéité à bague de glissement, comprenant
- un corps de base (2) avec une couche de diamant (3) appliquée sur le corps de base (2), laquelle est conçue comme une surface de glissement,
- la couche de diamant (3) présentant une épaisseur (D) qui est inférieure ou égale à 4 µm, en particulier inférieure ou égale à 3 µm, en particulier inférieure ou égale à 2 µm, de manière particulièrement préférée environ égale à 1 µm,
**caractérisée en ce que**
le corps de base (2) ne présente aucune fissure ou seulement des fissures qui présentent une extension longitudinale (L) maximale inférieure ou égale à 5 µm sur une surface du corps de base (2) ou dans le corps de base (2).

2. Bague de glissement selon la revendication 1, **caractérisée en ce que** les fissures (4) dans le corps de base (2) présentent une profondeur de fissure (T) inférieure ou égale à 3 µm.

3. Bague de glissement selon l'une des revendications précédentes, **caractérisée en ce que** la couche de diamant (3) présente une épaisseur d'au moins 0,5 µm.

4. Bague de glissement selon l'une des revendications précédentes, **caractérisée en ce que** la surface du corps de base (2) est exempte de pores ou que la surface ne présente que des pores d'un diamètre de pore moyen inférieur ou égal à 0,4 mm, en particulier inférieur ou égal à 0,3 mm, de manière particulièrement préférée inférieur ou égal à 0,2 mm, et/ou que les pores (5) présentent entre eux une distance d'au moins 100 fois le diamètre de pore.

5. Bague de glissement selon l'une des revendications précédentes, **caractérisée en ce qu'**une taille de cristallite des diamants de la couche de diamant (3) est comprise entre 0,2 et 5 µm, en particulier entre 0,2 et 4 µm, de préférence entre 0,2 et 3 µm, de préférence entre 0,2 et 2,5 µm et en particulier entre 0,2 et 1 µm.

6. Bague de glissement selon l'une des revendications précédentes, **caractérisée en ce que** la couche de diamant (3) présente une rugosité (Rₐ) inférieure ou égale à 0,2 µm, en particulier inférieure ou égale à 0,15 µm, en particulier inférieure ou égale à 0,1 µm.

7. Bague de glissement selon l'une des revendications précédentes, **caractérisée en ce que** la couche de diamant (3) présente une proportion de SP3 supérieure ou égale à 97 %.

8. Bague de glissement selon l'une des revendications précédentes, **caractérisée en ce que** le corps de base (2) présente une dureté Vickers supérieure ou égale à 1400 HV.

9. Bague de glissement selon l'une des revendications précédentes, **caractérisée en ce qu'**une densité de défauts de la couche de diamant (3) est inférieure ou égale à 200 x 10⁻⁹, la densité de défauts étant le rapport entre l'aire des défauts et l'aire revêtue de la surface qui est exempte de défauts.

10. Bague de glissement selon l'une des revendications précédentes, **caractérisée en ce que** le corps de base (2) est fabriqué dans un matériau carburé, en particulier en carbure de silicium (SiC) ou en carbure de tungstène (WC).

11. Bague de glissement selon l'une des revendications précédentes, **caractérisée en ce que** la surface de la couche de diamant correspond à une surface du corps de base (2) avec un écart maximum de ± 0,2 µm.
